(19) Europäisches Patentamt
European Patent Office
Office européen des brevets

(11) **EP 2 869 459 B1**

(12) **EUROPÄISCHE PATENTSCHRIFT**

(45) Veröffentlichungstag und Bekanntmachung des Hinweises auf die Patenterteilung:
**17.06.2020   Patentblatt 2020/25**

(51) Int Cl.:
**H02P 9/10** (2006.01)          **F02D 41/02** (2006.01)
**F02D 31/00** (2006.01)

(21) Anmeldenummer: **14003561.9**

(22) Anmeldetag: **17.10.2014**

(54) **Verfahren zum Betreiben eines mit einem Energieversorgungsnetz verbundenen Generators**

Method for operating a generator connected to an energy supply network

Procédé de fonctionnement d'un générateur relié à un réseau d'alimentation électrique

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **30.10.2013   AT 8332013**

(43) Veröffentlichungstag der Anmeldung:
**06.05.2015   Patentblatt 2015/19**

(73) Patentinhaber: **Innio Jenbacher GmbH & Co OG**
**6200 Jenbach (AT)**

(72) Erfinder:
• **Gomez, Josè**
  **72764 Reutlingen (DE)**

• **Kruckenhauser, Erich**
  **6232 Muenster (AT)**
• **Schaumberger, Herbert**
  **6232 Muenster (AT)**

(74) Vertreter: **Torggler & Hofinger Patentanwälte**
**Postfach 85**
**6010 Innsbruck (AT)**

(56) Entgegenhaltungen:
**EP-A2- 2 312 741      DE-A1- 19 752 940**
**DE-C- 762 986        DE-C- 969 090**

EP 2 869 459 B1

**Beschreibung**

Die Erfindung betrifft ein Verfahren zum Betreiben eines mit einem Energieversorgungsnetz verbundenen Generators, insbesondere Synchrongenerators, während eines einen Back-swing Effekts zur Folge habenden Netzfehlers im Energieversorgungsnetz, insbesondere während eines elektrischen Kurzschlusses mit den Merkmalen des Oberbegriffs des Anspruchs 1.

Während eines Netzfehlers in einem Energieversorgungsnetz, insbesondere während eines elektrischen Kurzschlusses und dem damit verbundenen Abfall der Netzspannung im Energieversorgungsnetz, können an einem mit dem Energieversorgungsnetz verbundenen elektrischen Generator, insbesondere Synchrongenerator, unerwünschte Änderungen von Betriebsgrößen des Generators wie beispielsweise der Drehzahl oder des Lastwinkels auftreten. Als Lastwinkel wird bekannterweise der Winkel zwischen dem Vektor des rotierenden Magnetfeldes im Stator des Generators und dem Vektor des rotierenden Magnetfeldes im Rotor des Generators bezeichnet.

Der Abfall der Netzspannung führt zu einer signifikanten Verringerung der Abgabe von elektrischer Leistung vom Generator an das Energieversorgungsnetz. Bei üblichen Konfigurationen, bei denen ein Rotor des Generators mit einer den Rotor antreibenden Motorwelle einer Brennkraftmaschine (z.B. Gasmotor) verbunden ist, kann dieser elektrische Leistungsabfall zu einer entsprechenden Drehzahlerhöhung der Brennkraftmaschine und somit des Rotors führen. Dadurch kann die Synchronisation des Generators mit dem Energieversorgungsnetz verloren gehen oder sogar ein Schaden im Generator hervorgerufen werden.

Das Erkennen eines Netzfehlers im Energieversorgungsnetz kann beispielsweise dadurch erfolgen, dass die Netzspannung des Energieversorgungsnetzes und/oder der vom Generator in das Energieversorgungsnetz eingespeiste elektrische Strom und/oder die Drehzahl des Generators bzw. der Brennkraftmaschine und/oder das Drehmoment an der Motorwelle der Brennkraftmaschine bzw. an der Rotorwelle des Generators überwacht wird bzw. werden, wobei bei Auftreten einer Änderung mindestens einer dieser überwachten Betriebsgrößen über einen vorgebbaren Schwellwert ein Netzfehler detektiert wird. Dabei kann auch vorgesehen sein, dass auftretende Änderungen erst dann als Netzfehler detektiert werden, wenn mehrere dieser Betriebsgrößen entsprechende Änderungen über vorgebbare Schwellwerte aufweisen, wenn also beispielsweise sowohl die Netzspannung, der elektrische Strom und auch die Drehzahl entsprechende Abweichungen aufweisen. Der Generator kann während des Netzfehlers mit dem Energieversorgungsnetz verbunden bleiben.

Der herkömmliche Ansatz, um auf solche Netzfehler zu reagieren, ist es, entsprechende Maßnahmen zu ergreifen, um einer solchen Erhöhung der Drehzahl und einer damit verbundenen Erhöhung des Lastwinkels des Generators entgegenzuwirken. So werden üblicherweise Maßnahmen ergriffen, welche die Drehzahl und den Lastwinkel reduzieren. Eine solche beispielhafte Maßnahme ist die Reduzierung des Beschleunigungsmomentes, indem eine mit dem Generator verbundene Brennkraftmaschine entsprechend gedrosselt wird.

Es hat sich jedoch gezeigt, dass die herkömmlichen Maßnahmen bei einem Netzfehler in bestimmten Situationen nachteilig sind. So kann es vorkommen, dass sich die Drehzahl des Generators bei Auftreten eines Netzfehlers nicht erhöht, sondern zunächst abfällt. Dieser dem Fachmann unter dem englischen Fachbegriff "Back-swing" bekannte Effekt kann unter Umständen sogar zu Polschlupf des Generators führen. Polschlupf wiederum führt zu einer Instabilität des Generators, bei der eine von einer Brennkraftmaschine über die Motorwelle in den Rotor eingebrachte mechanische Leistung vom Generator nicht mehr wie gewünscht in elektrische Leistung umgewandelt werden kann. Stand der Technik ist z.B. in den Schriften DE 762 986 C, DE 969 090 C, EP 2 312 741 A2 oder DE 197 52 940 A1 gegeben.

Aufgabe der Erfindung ist es, die vorbeschriebenen Nachteile zu vermeiden und ein gegenüber dem Stand der Technik verbessertes Verfahren zum Betreiben eines Generators während eines Netzfehlers im Energieversorgungsnetz anzugeben.

Diese Aufgabe wird erfindungsgemäß durch die Merkmale des Patentanspruchs 1 gelöst. Vorteilhafte Ausgestaltungen der Erfindung sind in den abhängigen Patentansprüchen angegeben.

Gemäß der Erfindung ist also vorgesehen, dass eine elektrische Erregung des Generators abhängig vom Wert wenigstens einer Betriebsgröße des Generators vor dem Netzfehler und/oder während des Netzfehlers zumindest zeitweise verringert wird.

Die elektrische Erregung eines Generators bestimmt die übertragbare elektrische Leistung sowie die Höhe der Ausgangsspannung des Generators und damit die Höhe der elektrischen Blindleistung, die vom Generator in das Energieversorgungsnetz eingespeist wird. Je höher die Generatorausgangsspannung während eines Netzspannungseinbruchs, desto höher die elektrische Leistung, die in das Energieversorgungsnetz eingespeist wird. Durch das Reduzieren der elektrischen Erregung des Generators wird demnach die Höhe der elektrischen Leistung, die in das Energieversorgungsnetz während eines Netzspannungseinbruchs eingespeist wird, reduziert. Dies ist während eines Netzfehlers im Energieversorgungsnetz vorteilhaft, der einen Backswing Effekt zur Folge hat. Bei erfindungsgemäßen Konfigurationen, in denen eine Brennkraftmaschine den Generator antreibt, kann dadurch dem bei einem Netzfehler - insbesondere bei einem Back-swing - auftretenden Ungleichgewicht zwischen der mechanischen Leistung der Brennkraftmaschine und der vom Generator abgegebenen elektrischen Leistung vorteilhaft entgegengewirkt werden.

Das vorgeschlagene Verfahren ist insbesondere für Generatoren vorteilhaft, die eine Trägheitskonstante von kleiner gleich 1,5 Ws/VA, vorzugsweise kleiner gleich 1 Ws/VA aufweisen, da sich der Back-swing Effekt auf Generatoren mit geringen Trägheitskonstanten stärker auswirkt.

Erfindungsgemäß ist der Generator, vorzugsweise mittels einer Kupplungsvorrichtung, mit einer Brennkraftmaschine gekoppelt. Bei der Brennkraftmaschine kann es sich beispielsweise um einen ottomotorisch betriebenen Hubkolben-Gasmotor, einen Dieselmotor oder eine Gasturbine handeln.

Abweichungen von Betriebsgrößen des Generators während eines Netzfehlers treten häufig deshalb auf, weil ein Ungleichgewicht zwischen der mechanischen Leistung, die durch die Brennkraftmaschine in den Generator eingebracht wird, und der elektrischen Leistung, die vom Generator in das Energieversorgungsnetz eingespeist wird, auftritt. Im Falle eines in Folge des Netzfehlers auftretenden Back-swing Effekts kann dieses Ungleichgewicht dadurch hervorgerufen werden, dass die elektrische Leistung größer als die mechanische Leistung ist. Durch ein Absenken der elektrischen Erregung des Generators und der damit verbundenen Reduktion der abgegebenen elektrischen Leistung kann diesem Ungleichgewicht entgegengewirkt werden.

Es ist vorgesehen, dass die Erregung des Generators durch Verringerung einer Erregerspannung für den Generator oder durch Verringerung eines dem Generator zugeführten Erregerstroms verringert wird. Für die Erregung des Generators kann dabei eine Erregungsvorrichtung zum Einsatz kommen, die am oder außerhalb des Generators angeordnet ist. Die Erregungsvorrichtung wird mit der Erregerspannung beaufschlagt und stellt in weiterer Folge einen Erregerstrom bereit, der in bekannter Art und Weise entsprechenden Wicklungen des Generators zugeführt wird, um die Erregung des Generators zu bewirken.

Gemäß einer bevorzugten Ausführungsform der Erfindung kann vorgesehen sein, dass als Betriebsgröße eine vom Generator an das Energieversorgungsnetz abgegebene elektrische Leistung vor dem Netzfehler erfasst wird, wobei die Erregung abhängig von der abgegebenen elektrischen Leistung vor dem Netzfehler verringert wird. Dabei kann die Erregung im Wesentlichen proportional zu einer Differenz der abgegebenen elektrischen Leistung vor dem Netzfehler zu einem vorgebbaren Referenzwert - vorzugsweise der Nennleistung - verringert werden.

Vorzugsweise kann vorgesehen sein, dass als Betriebsgröße während des Netzfehlers eine transiente Drehzahl des Generators und/oder der Kupplungsvorrichtung und/oder der Brennkraftmaschine erfasst wird, wobei die Erregung im Wesentlichen proportional zu einer Differenz der transienten Drehzahl zur Drehzahl vor dem Netzfehler verringert wird.

Beispielsweise kann eine prozentuale Erregerspannung in Bezug auf eine vorgebbare Nennerregerspannung von 100% gemäß folgender Formel F1 ermittelt werden:

$$S3=100\% - (S1_{ref}-S1)*P_{speed},$$

wobei S3 eine prozentuale Erregerspannung bezüglich einer Nennerregerspannung von 100% bezeichnet, S1$_{ref}$ eine prozentuale Drehzahl des Generators oder der Kupplungsvorrichtung oder der Brennkraftmaschine vor dem Netzfehler in Bezug auf eine Nenndrehzahl von 100% bezeichnet, S1 die prozentuale transiente Drehzahl des Generators oder der Kupplungsvorrichtung oder der Brennkraftmaschine während des Netzfehlers in Bezug auf eine Nenndrehzahl von 100% bezeichnet und P$_{speed}$ einen positiven Proportionalitätsfaktor bezeichnet, durch den die Intensität der Verringerung der Erregerspannung beeinflusst werden kann.

Gemäß einer weiteren Ausführungsform kann vorgesehen sein, dass als Betriebsgröße während des Netzfehlers eine Drehzahländerung der Drehzahl des Generators und/oder der Kupplungsvorrichtung und/oder der Brennkraftmaschine erfasst wird, wobei die Erregung abhängig von der Höhe der Drehzahländerung verringert wird.

Es kann auch vorgesehen sein, dass als Betriebsgröße während des Netzfehlers ein Drehmoment an einer Motorwelle der Brennkraftmaschine und/oder an einer Rotorwelle des Generators erfasst wird, wobei die Erregung abhängig vom Drehmoment verringert wird.

Bei einer weiteren bevorzugten Ausführungsform kann vorgesehen sein, dass als Betriebsgröße während des Netzfehlers ein Lastwinkel des Generators erfasst wird, wobei die Erregung im Wesentlichen indirekt proportional zur Größe des erfassten Lastwinkels verringert wird.

Beispielsweise kann eine verringerte Erregerspannung gemäß folgender Formel F2 bei einem negativen Lastwinkel ermittelt werden:

$$S3=100\% + (S2/180)*100\%*P_{load\_angle},$$

wobei S3 die gegenüber der Nennerregerspannung von 100% entsprechend prozentual verringerte Erregerspannung bezeichnet, S2 den gemessenen negativen Lastwinkel in Grad bezeichnet und P$_{load\_angle}$ einen positiven Proportionalitätsfaktor bezeichnet, durch den die Intensität der Verringerung der Erregerspannung beeinflusst werden kann.

Vorzugsweise kann vorgesehen sein, dass die Erregung maximal bis auf eine vorgebbare Minimalerregung verringert wird. Damit kann eine Minimalerregung des Generators sichergestellt werden. So kann z.B. ein Minimalwert für die Größe S3 der oben angeführten Formeln F1 bzw. F2 vorgegeben werden, unter den die prozentuale Erregerspannung nicht abgesenkt werden soll. Durch diese Sicherheitsmaßnahme können kritische Betriebszustände der Brennkraftmaschine vermieden werden.

Gemäß einer besonders bevorzugten Ausführung kann vorgesehen sein, dass Schwingungen einer Betriebsgröße des Generators während des Netzfehlers erfasst werden, wobei die Erregung des Generators verringert wird, falls die Schwingungen eine vorgebbare Intensität überschreiten. Dabei kann vorgesehen sein, dass Schwingungen eines Lastwinkels des Generators erfasst werden, wobei die Erregung des Generators verringert wird, falls die Schwingungen eine Amplitude von mehr als 2 Grad, vorzugsweise mehr als 10 Grad, aufweisen.

Im Falle eines Netzfehlers, der einen Back-swing Effekt zur Folge hat, ist es vorgesehen, die mechanische Leistung der Brennkraftmaschine zu erhöhen, um die Erhöhung der elektrischen Leistung, die der Generator in das Energieversorgungsnetz einspeist, zu kompensieren. Falls die Reaktionszeit der entsprechenden Stellorgane der Brennkraftmaschine in Bezug auf die Zeitdauer des Netzfehlers zu groß ist, können die Stellorgane der Brennkraftmaschine in Ihren Positionen gehalten werden, sodass zumindest die von der Brennkraftmaschine eingebrachte mechanische Leistung auf dem Niveau bleibt, das vor dem Netzfehler geherrscht hat.

Weitere Einzelheiten und Vorteile der vorliegenden Erfindung werden anhand der nachfolgenden Figurenbeschreibung erläutert. Dabei zeigen:

Fig. 1    ein schematisches Blockschaltbild eines mit einem Energieversorgungsnetz elektrisch verbundenen Generators, der von einer Brennkraftmaschine angetrieben wird und

Fig. 2    den zeitlichen Verlauf des Lastwinkels eines Generators während eines Netzfehlers im Energieversorgungsnetz.

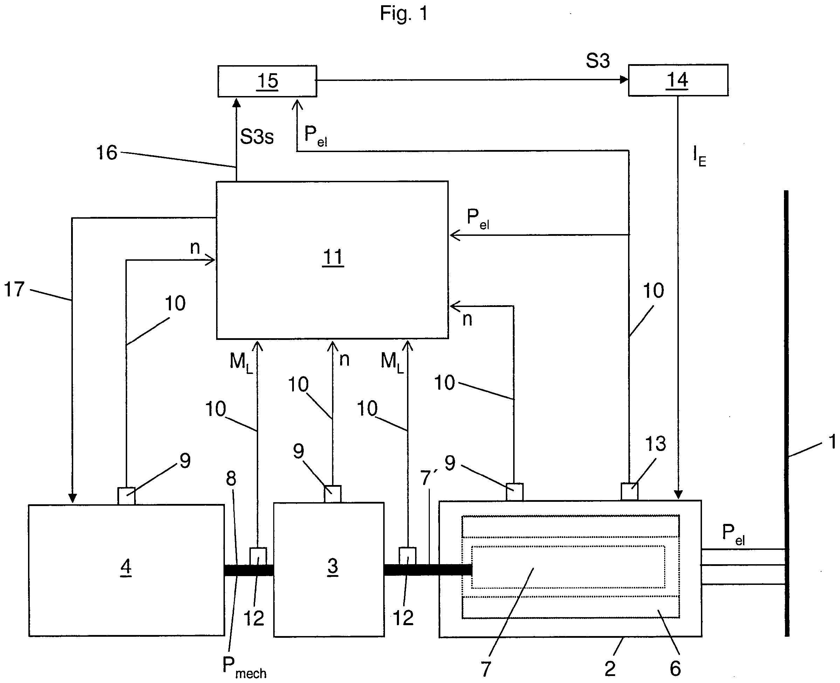

Figur 1 zeigt in einem schematischen Blockschaltbild einen elektrischen Generator 2, der mit einem dreiphasig ausgebildeten Energieversorgungsnetz 1 elektrisch verbunden ist. Der Generator 2 ist als Synchrongenerator ausgebildet und weist einen Stator 6 und einen innerhalb des Stators 6 drehbar angeordneten Rotor 7 auf. Die drei Phasen des Energieversorgungsnetzes 1 sind in bekannter Art und Weise mit Wicklungen am Stator 6 des Generators 2 verbunden. Beim Energieversorgungsnetz 1 kann es sich um ein öffentliches Energieversorgungsnetz handeln, das die Netzfrequenz vorgibt, oder beispielsweise um ein lokales Energieversorgungsnetz im Inselbetrieb, bei dem die Netzfrequenz vom Generator 2 vorgegeben wird. Der Rotor 7 bzw. Läufer des Generators 2 ist über eine Kupplungsvorrichtung 3 mit einer Motorwelle 8 einer Brennkraftmaschine 4 im Wesentlichen drehfest verbunden. Bei der Brennkraftmaschine 4 kann es sich z.B. um einen stationären Gasmotor handeln, der als fremd gezündete, ottomotorisch betriebene Hubkolbenmaschine ausgebildet sein kann.

Eine von der Brennkraftmaschine 4 abgegebene mechanische Leistung $P_{mech}$ wird über die Motorwelle 8 in den Generator 2 eingebracht, im Generator 2 in elektrische Leistung $P_{el}$ umgewandelt, und in weiterer Folge wird die elektrische Leistung $P_{el}$ an das Energieversorgungsnetz 1 abgegeben.

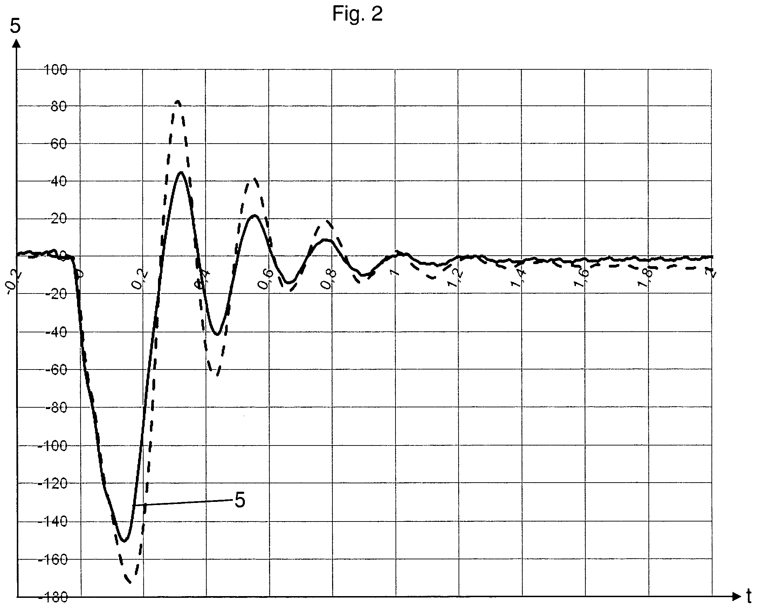

Im gezeigten Beispiel sind am Generator 2, an der Kupplungsvorrichtung 3 und an der Brennkraftmaschine 4 im Stand der Technik bekannte Drehzahlsensoren 9 angeordnet, durch welche die Drehzahl n der Motorwelle 8 bzw. des Rotors 7 erfasst und über entsprechende Signalleitungen 10 an eine Steuervorrichtung 11 gemeldet werden können. Weiters sind hier an der Motorwelle 8 und an der Rotorwelle 7' des Rotors 7 Drehmomentsensoren 12 angeordnet, mit denen das mechanische Drehmoment $M_L$ an der Motorwelle 8 vor der Kupplungsvorrichtung 3 sowie an der Rotorwelle 7' nach der Kupplungsvorrichtung 3 erfasst und über entsprechende Signalleitungen 10 an die Steuervorrichtung 11 gemeldet werden können. Die Steuervorrichtung 11 kann in weiterer Folge beispielsweise aus der erfassten Drehzahl n in bekannter Art und Weise den vorherrschenden Lastwinkel 5 des Rotors 7 ermitteln (siehe Fig. 2). Der Lastwinkel 5 kann rechnerisch auch auf Basis von Generatorreaktanzen und gemessenen elektrischen Größen (z.B. Spannung, Strom, Leistungsfaktor) ermittelt werden.

Des Weiteren ist am Generator 2 eine ebenso im Stand der Technik bekannte Leistungsmessung 13 angeordnet, welche die vom Generator 2 in das Energieversorgungsnetz 1 eingespeiste elektrische Leistung $P_{el}$ ermittelt und über eine weitere Signalleitung 10 an die Steuervorrichtung 11 und an einen Spannungsregler 15 meldet. Die Leistungsmessung 13 kann dabei in bekannter Weise aus Spannungs- und Strommessungen die elektrische Leistung $P_{el}$ ermitteln.

Der Rotor 7 des Generators weist hier nicht näher dargestellte Erregerwicklungen auf, die von einer Erregungsvorrichtung 14 in Form einer Synchronmaschine mit einem elektrischen Erregerstrom $I_E$ beaufschlagt werden. Die Erregungsvorrichtung 14 wird von einem Spannungsregler 15 mit einer Erregerspannung S3 beaufschlagt, wodurch sich ein der Erregerspannung S3 entsprechender Erregerstrom $I_E$ für die Erregerwicklungen am Rotor 7 des Generators 2 einstellt.

Während eines Netzfehlers im Energieversorgungsnetz 1 , der einen Back-swing Effekt zur Folge hat, ermittelt die Steuervorrichtung 11 abhängig vom Wert wenigstens einer Betriebsgröße des Generators 2 vor dem Netzfehler und/oder während des Netzfehlers eine entsprechend verringerte Maximalspannung S3s, die als maximale Erregerspannung S3 vom Spannungsregler 15 ausgegeben werden soll, und meldet diese Maximalspannung S3s über eine Steuerleitung 16 an den Spannungsregler 15. Durch die mittels Maximalspannung S3s limitierte maximale Erregerspannung S3, die nunmehr vom Spannungsregler 15 ausgebbar ist, kann eine Reduktion der daraus resultierenden Erregung des Generators 2 erzielt werden, indem dadurch der von der Erregungsvorrichtung 14 bereitgestellte Erregerstrom $I_E$ für die Erregerwicklungen am Rotor 7 des Generators 2 entsprechend reduziert wird. Bei der Erregerspannung S3 kann es sich um eine prozentuale Erregerspannung bezüglich einer Nennerregerspannung von 100% handeln. Die gegenüber der Nennerregerspannung verringerte, prozentuale Erregerspannung S3 kann dabei von der Steuervorrichtung 11 und/oder dem Spannungsregler 15 gemäß den obigen Formeln F1 bzw. F2 ermittelt werden.

Über eine Motorsteuerleitung 17 können nicht näher dargestellte Stellorgane der Brennkraftmaschine 4 angesteuert werden, um die von der Brennkraftmaschine 4 abgegebene mechanische Leistung zu verändern. Bei den Stellorganen kann es sich z.B. um eine Drosselklappe, ein Turbolader-Bypassventil oder ein Wastegate handeln. Im Falle eines Back-swings wird somit über die Motorsteuerleitung 17 die mechanische Leistung der Brennkraftmaschine 4 erhöht, um die Erhöhung der elektrischen Leistung, die der Generator 2 in das Energieversorgungsnetz 1 einspeist, zu kompensieren. Falls die Reaktionszeit der entsprechenden Stellorgane der Brennkraftmaschine 4 in Bezug auf die Zeitdauer des Netzfehlers zu groß ist, werden die Stellorgane der Brennkraftmaschine 4 in ihren Positionen gehalten, sodass zumindest die von der Brennkraftmaschine 4 eingebrachte mechanische Leistung auf dem Niveau bleibt, das vor dem Netzfehler geherrscht hat.

Figur 2 zeigt den zeitlichen Verlauf des Lastwinkels 5 des Rotors 7 des Generators 2 in Grad über die Zeit t in Sekunden während eines Netzfehlers, der einen Back-swing Effekt zur Folge hat. Wie in der Abbildung zu erkennen ist, treten während des Netzfehlers Schwingungen des Lastwinkels 5 auf. Der strichlierte Verlauf zeigt die Schwingungen des Lastwinkels 5 bei Anwendung herkömmlicher Steuermaßnahmen in Bezug auf den Netzfehler und die durchgezogene Linie zeigt den Verlauf des Lastwinkels 5 bei Anwendung des vorgeschlagenen Verfahrens. Wie deutlich zu erkennen ist, wird bei Anwendung des vorgeschlagenen Verfahrens die Amplitude der Schwingung des Lastwinkels 5 reduziert, wodurch sich insgesamt eine höhere Stabilität des Generators 2 während des Netzfehlers ergibt. In Bezug auf diese Abbildung ist anzumerken, dass ein Lastwinkel 5 von + oder - 180 Grad die Schlupfgrenze darstellt und daher, wie zu erkennen ist, der Generator 2 ohne das vorgeschlagene Verfahren bereits sehr nahe an die Schlupfgrenze herangeführt wird.

Insgesamt kann durch das vorgeschlagene Verfahren die Stabilität von elektrischen Generatoren bzw. Kraftanlagen umfassend wenigstens einen von einer Brennkraftmaschine angetriebenen elektrischen Generator in Situationen erhöht werden, in denen ein durch einen Netzfehler ausgelöster Back-swing Effekt auftritt. Während solcher Fehlersituationen mit Back-swing Effekt sind herkömmliche Steuermaßnahmen kontraproduktiv, da herkömmliche Steuermaßnahmen den Back-swing Effekt nicht beachten und beispielsweise die Erregung des Generators erhöhen anstatt diese zu verringern.

Vorzugsweise kann das vorgeschlagene Verfahren bei einem Netzfehler nur während des Auftretens eines Back-swing Effekts zum Einsatz kommen und nach Abklingen des Back-swing Effekts können wieder herkömmliche Steuermaßnahmen ergriffen werden.

**Patentansprüche**

1. Verfahren zum Betreiben eines mit einem Energieversorgungsnetz (1) verbundenen Generators (2), insbesondere Synchrongenerators, während eines einen Back-swing Effekts zur Folge habenden Netzfehlers im Energieversorgungsnetz (1), insbesondere während eines elektrischen Kurzschlusses, wobei der Generator (2), vorzugsweise mittels einer Kupplungsvorrichtung (3), mit einer Brennkraftmaschine (4) gekoppelt ist, und wobei eine elektrische Erregung des Generators (2) abhängig vom Wert wenigstens einer Betriebsgröße des Generators (2) vor dem Netzfehler und/oder während des Netzfehlers zumindest zeitweise verringert wird, **dadurch gekennzeichnet, dass**

   - die zeitweise Verringerung der elektrischen Erregung des Generators (2) durch eine Limitierung einer maximalen Erregerspannung (S3) einer Erregungsvorrichtung (14) des Generators (2) erfolgt, wobei eine abhängig vom Wert der wenigstens einen Betriebsgröße ermittelte, verringerte Maximalspannung (S3s) als maximale Erregerspannung (S3) an einen Spannungsregler (15) der Erregungsvorrichtung (14) übermittelt wird, um einen von der Erregungsvorrichtung (14) des Generators (2) bereitgestellten Erregerstrom ($I_E$) für die Erregerwicklungen eines Rotors (7) des Generators (2) zu reduzieren und dass

   - die mechanische Leistung der Brennkraftmaschine (4) erhöht wird, um die Erhöhung der elektrischen Leistung, die der Generator (2) in das Energieversorgungsnetz (1) einspeist, zu kompensieren oder - falls die Reaktionszeit der entsprechenden Stellorgane der Brennkraftmaschine (4) in Bezug auf die Zeitdauer des Netzfehlers zu groß ist - Stellorgane der Brennkraftmaschine (4), durch welche die von der Brennkraftmaschine (4) abgegebene mechanische Leistung veränderbar ist, in ihren Positionen gehalten werden, sodass zumindest die von der Brennkraftmaschine (4) eingebrachte mechanische Leistung auf dem Niveau bleibt, das vor dem Netzfehler geherrscht hat.

2. Verfahren nach Anspruch 1, **dadurch gekennzeichnet, dass** der Generator (2) eine Trägheitskonstante von kleiner gleich 1,5 Ws/VA, vorzugsweise kleiner gleich 1 Ws/VA aufweist.

3. Verfahren nach einem der Ansprüche 1 bis 2, **dadurch gekennzeichnet, dass** die Erregung des Generators (2) durch Verringerung einer Erregerspannung (S3) für den Generator (2) oder durch Verringerung eines dem Generator (2) zugeführten Erregerstroms ($I_E$) verringert wird.

4. Verfahren nach einem der Ansprüche 1 bis 3, **dadurch gekennzeichnet, dass** als Betriebsgröße eine vom Generator (2) an das Energieversorgungsnetz (1) abgegebene elektrische Leistung ($P_{el}$) vor dem Netzfehler erfasst wird, wobei die Erregung abhängig von der abgegebenen elektrischen Leistung ($P_{el}$) vor dem Netzfehler verringert wird.

5. Verfahren nach Anspruch 4, **dadurch gekennzeichnet, dass** die Erregung im Wesentlichen proportional zu einer Differenz der abgegebenen elektrischen Leistung ($P_{el}$) vor dem Netzfehler zu einem vorgebbaren Referenzwert - vorzugsweise der Nennleistung - verringert wird.

6. Verfahren nach einem der Ansprüche 1 bis 5, **dadurch gekennzeichnet, dass** als Betriebsgröße während des Netzfehlers eine transiente Drehzahl des Generators (2) und/oder der Kupplungsvorrichtung (3) und/oder der Brennkraftmaschine (4) erfasst wird, wobei die Erregung im Wesentlichen proportional zu einer Differenz der transienten Drehzahl zur Drehzahl vor dem Netzfehler verringert wird.

7. Verfahren nach einem der Ansprüche 1 bis 6, **dadurch gekennzeichnet, dass** als Betriebsgröße während des Netzfehlers eine Drehzahländerung der Drehzahl des Generators (2) und/oder der Kupplungsvorrichtung (3) und/oder der Brennkraftmaschine (4) erfasst wird, wobei die Erregung abhängig von der Höhe der Drehzahländerung verringert wird.

8. Verfahren nach einem der Ansprüche 1 bis 7, **dadurch gekennzeichnet, dass** als Betriebsgröße während des Netzfehlers ein Drehmoment ($M_L$) an einer Motorwelle (8) der Brennkraftmaschine (4) und/oder an einer Rotorwelle (7') des Generators (2) erfasst wird, wobei die Erregung abhängig vom Drehmoment ($M_L$) verringert wird.

9. Verfahren nach einem der Ansprüche 1 bis 8, **dadurch gekennzeichnet, dass** als Betriebsgröße während des Netzfehlers ein Lastwinkel (5) des Generators (2) erfasst wird, wobei die Erregung im Wesentlichen indirekt proportional zur Größe des erfassten Lastwinkels (5) verringert wird.

10. Verfahren nach einem der Ansprüche 1 bis 9, **dadurch gekennzeichnet, dass** die Erregung maximal bis auf eine vorgebbare Minimalerregung verringert wird.

11. Verfahren nach einem der Ansprüche 1 bis 10, **dadurch gekennzeichnet, dass** Schwingungen einer Betriebsgröße des Generators (2) während des Netzfehlers erfasst werden, wobei die Erregung des Generators (2) verringert wird, falls die Schwingungen eine vorgebbare Intensität überschreiten.

12. Verfahren nach Anspruch 11, **dadurch gekennzeichnet, dass** Schwingungen eines Lastwinkels (5) des Generators (2) erfasst werden, wobei die Erregung des Generators (2) verringert wird, falls die Schwingungen eine Amplitude von mehr als 2 Grad, vorzugsweise mehr als 10 Grad, aufweisen.

**Claims**

1. A method of operating a generator (2) connected to a power supply network (1), in particular a synchronous generator, during a network fault in the power supply network (1), that results in a back-swing effect, in particular during an electric short-circuit, wherein the generator (2) is coupled to an internal combustion engine (4), preferably by means of a coupling device (3), and wherein electric excitation of the generator (2) is at least temporarily reduced in dependence on the value of at least one operating parameter of the generator (2) prior to the network fault and/or during the network fault, **characterised in that**

   - to temporarily reducing of the electric excitation of the generator (2) a limitation of a maximum exciter voltage (S3) is done by a excitation device (14) of the generator (2), wherein in dependence on the value of at least one operating parameter an determined, reduced maximum voltage (S3s) is forwarded as maximum exciter voltage (S3) to a voltage regulator (15) of the excitation device (14), to reduce the exciter current ($I_E$) provided by the excitation device (14) for the exciter windings on the rotor (7) of the generator (2) and that
   - the mechanical power of the internal combustion engine (4) is increased in order to compensate for the increase in electric power fed into the power supply network (1) by the generator (2) or - if the reaction time of the corresponding control members of the internal combustion engine (4) in relation to the time duration of the network fault is too great - control members of the internal combustion engine (4), through which the mechanical power delivered by the internal combustion engine (1) can be changed, are kept in their positions so that at least the mechanical power introduced by the internal combustion engine (4) remains at the level that prevailed prior to the network fault.

2. Method as set forth in claim 1 **characterised in that** the generator (2) has an inertia constant of less than or equal to 1.5 Ws/VA, preferably less than or equal to 1 Ws/VA.

3. Method as set forth in one of claims 1 through 2 **characterised in that** excitation of the generator (2) is reduced by reducing an exciter voltage (S3) for the generator (2) or by reducing an exciter current ($I_E$) fed to the generator (2).

4. Method as set forth in one of claims 1 through 3 **characterised in that** an electric power ($P_{el}$) delivered to the power supply network (1) by the generator (2) prior to the network fault is detected as an operating parameter, wherein excitation is reduced in dependence on the delivered electric power ($P_{el}$) prior to the network fault.

5. Method as set forth in claim 4 **characterised in that** excitation is reduced substantially proportionally to a difference in the delivered electric power ($P_{el}$) prior to the network fault in relation to a predeterminable reference value, preferably the rated power.

6. Method as set forth in one of claims 1 through 5 **characterised in that** a transient rotary speed of the generator (2) and/or the coupling device (3) and/or the internal combustion engine (4) is detected as the operating parameter during the network fault, wherein excitation is reduced substantially proportionally to a difference in the transient rotary speed relative to the rotary speed prior to the network fault.

7. Method as set forth in one of claims 1 through 6 **characterised in that** a change in rotary speed of the generator (2) and/or the coupling device (3) and/or the internal combustion engine (4) is detected as the operating parameter during the network fault, wherein excitation is reduced in dependence on the magnitude of the change in rotary speed.

8. Method as set forth in one of claims 1 through 7 **characterised in that** a torque ($M_L$) at an engine shaft (8) of the internal combustion engine (4) and/or at a rotor shaft (7) of the generator (2) is detected as the operating parameter during the network fault, wherein excitation is reduced in dependence on the torque ($M_L$).

9. Method as set forth in one of claims 1 through 8 **characterised in that** a load angle (5) of the generator (2) is detected as the operating parameter during the network fault, wherein excitation is reduced substantially indirectly proportionally to the magnitude of the detected load angle (5).

10. Method as set forth in one of claims 1 through 9 **characterised in that** excitation is reduced at a maximum to a predeterminable minimum excitation.

11. Method as set forth in one of claims 1 through 10 **characterised in that** oscillations in an operating parameter of the generator (2) during the network fault are detected, wherein excitation of the generator (2) is reduced if the oscillations exceed a predeterminable intensity.

12. Method as set forth in claim 11 **characterised in that** oscillations in a load angle (5) of the generator (2) are detected, wherein excitation of the generator (2) is reduced if the oscillations are of an amplitude of more than 2 degrees, preferably more than 10 degrees.

## Revendications

1. Procédé d'exploitation d'un générateur (2) relié à un réseau d'approvisionnement en énergie (1), en particulier d'un générateur synchrone, pendant une défaillance de réseau, dans le réseau d'approvisionnement en énergie (1), ayant pour conséquence un effet back-swing, en particulier pendant un court-circuit électrique, dans lequel le générateur (2), est couplé à un moteur à combustion interne (4) de préférence au moyen d'un dispositif de couplage (3), et dans lequel une excitation électrique du générateur (2) est au moins partiellement diminuée en fonction de la valeur d'au moins une grandeur d'exploitation du générateur (2) avant la défaillance de réseau et/ou pendant la défaillance de réseau, **caractérisé en ce que**

   - la diminution temporaire de l'excitation électrique du générateur (2) se produit via une limitation d'une tension d'excitation (S3) maximale d'un dispositif d'excitation (14) du générateur (2), dans lequel une tension maximale (S3s) déterminée et diminuée en fonction de la valeur de la au moins une grandeur d'exploitation est transmise en tant que tension d'excitation (S3) maximale à un régulateur de tension (15) du dispositif d'excitation (14) afin de réduire un courant d'excitation ($I_E$) mis à disposition par le dispositif d'excitation (14) du générateur (2) pour les enroulements d'excitation d'un rotor (7) du générateur (2), et **en ce que**
   - la puissance mécanique du moteur à combustion interne (4) est augmentée afin de compenser l'augmentation de la puissance électrique que le générateur (2) amène jusque dans le réseau d'approvisionnement en énergie (1), ou - dans le cas où le temps de réaction des organes de réglage correspondants du moteur à combustion interne (4) par rapport à la durée de la défaillance de réseau est trop élevé - des organes de réglage du moteur à combustion interne (4) via lesquels la puissance mécanique délivrée par le moteur à combustion interne (4) peut être modifiée sont maintenus dans leurs positions, de sorte qu'au moins la puissance mécanique rapportée par le moteur à combustion interne (4) demeure au niveau qui régnait avant la défaillance de réseau.

2. Procédé selon la revendication 1, **caractérisé en ce que** le générateur (2) présente une constante d'inertie inférieure ou égale à 1,5 W.s/VA, de préférence inférieure ou égale à 1 W.s/VA.

3. Procédé selon l'une des revendications 1 à 2, **caractérisé en ce que** l'excitation du générateur (2) est diminuée par diminution d'une tension d'excitation (S3) pour le générateur (2) ou par diminution d'un courant d'excitation ($I_E$) acheminé vers le générateur (2).

4. Procédé selon l'une des revendications 1 à 3, **caractérisé en ce qu'**une puissance électrique ($P_{el}$) délivrée depuis le générateur (2) au réseau d'approvisionnement en énergie (1) avant la défaillance de réseau est saisie en tant que grandeur d'exploitation, dans lequel l'excitation est diminuée en fonction de la puissance électrique ($P_{el}$) délivrée avant la défaillance de réseau.

5. Procédé selon la revendication 4, **caractérisé en ce que** l'excitation est diminuée essentiellement proportionnellement à une différence entre la puissance électrique ($P_{el}$) délivrée avant la défaillance de réseau et une valeur de référence- de préférence de la puissance nominale - pouvant être prédéfinie.

6. Procédé selon l'une des revendications 1 à 5, **caractérisé en ce qu'**une vitesse de rotation transitoire du générateur (2) et/ou du dispositif de couplage (3) et/ou du moteur à combustion interne (4) est saisie en tant que grandeur d'exploitation pendant la défaillance de réseau, dans lequel l'excitation est diminuée essentiellement proportionnellement à une différence entre la vitesse de rotation transitoire et la vitesse de rotation avant la défaillance de réseau.

7. Procédé selon l'une des revendications 1 à 6, **caractérisé en ce qu'**une modification de vitesse de rotation de la vitesse de rotation du générateur (2) et/ou du dispositif de couplage (3) et/ou du moteur à combustion interne (4) est saisie en tant que grandeur d'exploitation pendant la défaillance de réseau, dans lequel l'excitation est diminuée en fonction du niveau de la modification de vitesse de rotation.

8. Procédé selon l'une des revendications 1 à 7, **caractérisé en ce qu'**un moment de rotation ($M_L$) au niveau d'un arbre moteur (8) du moteur à combustion interne (4) et/ou au niveau d'un arbre rotor (7') du générateur (2) est saisi en tant que grandeur d'exploitation pendant la défaillance de réseau, dans lequel l'excitation est diminuée en fonction du moment de rotation ($M_L$).

9. Procédé selon l'une des revendications 1 à 8, **caractérisé en ce qu'**un angle de charge (5) du générateur (2) est saisi en tant que grandeur d'exploitation pendant la défaillance de réseau, dans lequel l'excitation est diminuée essentiellement indirectement proportionnellement à la taille de l'angle de charge (5) saisi.

10. Procédé selon l'une des revendications 1 à 9, **caractérisé en ce que** l'excitation est diminuée au maximum jusqu'à une excitation minimale pouvant être prédéfinie.

11. Procédé selon l'une des revendications 1 à 10, **caractérisé en ce que** des oscillations d'une grandeur d'exploitation du générateur (2) pendant la défaillance de réseau sont saisies, dans lequel l'excitation du générateur (2) est diminuée si les oscillations dépassent une intensité pouvant être prédéfinie.

12. Procédé selon la revendication 11, **caractérisé en ce que** des oscillations d'un angle de charge (5) du générateur (2) sont saisies, dans lequel l'excitation du générateur (2) est diminuée si les oscillations présentent une amplitude de plus de 2 degrés, de préférence plus de 10 degrés.

Fig. 1

EP 2 869 459 B1

Fig. 2

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 762986 C
- DE 969090 C
- EP 2312741 A2
- DE 19752940 A1